Europäisches Patentamt

European Patent Office

Office européen des brevets

(1) Numéro de publication: **0 033 704**
**B1**

(12) **FASCICULE DE BREVET EUROPEEN**

(45) Date de publication du fascicule du brevet: **14.11.84**

(51) Int. Cl.³: **G 01 N 24/04**

(21) Numéro de dépôt: **81400159.0**

(22) Date de dépôt: **03.02.81**

(54) **Système de bobines électromagnétiques pour l'examen de corps humains au moyen de la résonance magnétique nucléaire, et appareil d'imagerie du corps humain utilisant un tel système.**

(30) Priorité: **05.02.80 FR 8002497**

(43) Date de publication de la demande:
**12.08.81 Bulletin 81/32**

(45) Mention de la délivrance du brevet:
**14.11.84 Bulletin 84/46**

(84) Etats contractants désignés:
**DE FR GB NL**

(56) Documents cités:
**EP-A-0 026 265**
**EP-A-0 031 489**
**EP-A-0 033 703**
**DE-A-2 755 956**

(73) Titulaire: **THOMSON-CSF**
**173, Boulevard Haussmann**
**F-75379 Paris Cedex 08 (FR)**
(73) Titulaire: **ANVAR Agence Nationale de Valorisation de la Recherche**
**43, rue Caumartin**
**F-75436 Paris Cédex 09 (FR)**

(72) Inventeur: **Barjhoux, Yves**
**THOMSON-CSF SCPI 173, bld Haussmann**
**F-75360 Paris Cedex 08 (FR)**
Inventeur: **Saint Jalmes, Hervé**
**THOMSON-CSF SCPI 173, bld Haussmann**
**F-75360 Paris Cedex 08 (FR)**
Inventeur: **Taquin, Jacques**
**THOMSON-CSF SCPI 173, bld Haussmann**
**F-75360 Paris Cedex 08 (FR)**

(74) Mandataire: **Barbin le Bourhis, Joel et al**
**THOMSON-CSF SCPI 173, boulevard Haussmann**
**F-75379 Paris Cedex 08 (FR)**

Courier Press, Leamington Spa, England.

# Description

La présente invention concerne une nouvelle configuration d'un système de bobines électromagnétiques, permettant d'obtenir des images de l'intérieur du corps humain dans de meilleures conditions que précédemment. L'imagerie par Résonance Magnétique Nucléaire (RMN) nécessite des temps de pose souvent très longs (jusqu'à une heure). La nouvelle configuration proposée pour le système de bobines électromagnétiques, c'est-à-dire l'électro-aimant d'une part, et la bobine de RMN d'autre part, doit permettre de réduire ces temps de pose d'un facteur supérieur à 2. Elle rend plus pratique l'utilisation médicale de cette méthode de diagnostic non traumatisant.

La méthode d'imagerie par RMN utilise la Résonance Magnétique Nucléaire de noyaux contenus dans le corps humain. Cette méthode est maintenant bien connue en elle-même; elle est par exemple décrite par W. Hinshaw et al. dans la revue "British Journal of Radiology" n° 52,36 (1979). Le plus souvent, l'espèce observée est le noyau de l'hydrogène qui est présent en abondante concentration dans tous les tissus. La quantité observée par RMN est l'aimantation de ces noyaux; elle est proportionnelle au champ magnétique $H_0$ dans lequel le patient est placé. De nombreuses méthodes de construction d'images ont été décrites dans la littérature scientifique, voir par exemple, l'article de P. Brunner et R. P. Ernst dans la revue "Journal of Magnetic Resonance" n° 33,83 (1979). Leur application à l'imagerie du corps entier (au niveau du thorax ou de l'abdomen) nécessite des temps de pose très longs, allant parfois jusqu'à plusieurs heures. La raison vient essentiellement de la très faible valeur de l'aimantation nucléaire: le rapport signal-sur-bruit $\psi$ de chaque élément d'image n'atteint une valeur acceptable qu'au bout de temps d'accumulation ou "temps" de pose" assez longs. Il est clair que l'imagerie par RMN ne pourra véritablement être utilisée systématiquement comme méthode de diagnostic médical que si ces temps de pose peuvent être notablement réduits; c'est un des buts de la présente invention dans laquelle une construction et une organisation du système de bobines, différentes de celles de l'art antérieur, vont permettre d'accroître la sensibilité et donc de réduire les "temps de pose".

On a cherché, dans l'art antérieur, à augmenter la sensibilité en augmentant la quantité mesurée, c'est-à-dire en augmentant le champ magnétique $\vec{H}_0$ appliqué sur le patient par l'électro-aimant dans lequel il est longitudinalement situé. En effet, on montre que le rapport signal-sur-bruit est approximativement proportionnel à $H_0$. Il est donc opportun d'utiliser un champ $\vec{H}_0$ aussi intense que possible. En fait, il faut se limiter à quelques dixièmes de Teslas pour des raisons de détection de le RMN: la fréquence de résonance est proportionnelle à $H_0$, et lorsque $H_0$ atteint 0,5 Tesla, elle devient trop élevée pour que les ondes électromagnétiques puissent traverser le corps humain sans atténuation notable; il apparaît alors sur les images de RMN des distorsions difficiles à corriger.

Classiquement, dans les dispositifs connus, le champ $\vec{H}_0$ est produit par un électro-aimant résistif (pour des valeurs de $H_0$ allant jusqu'à 0,2 Tesla) ou supraconducteur (pour les valeurs plus élevées); le sujet à examiner est placé longitudinalement dans le champ $\vec{H}_0$ ainsi crée.

Les demandes de brevet européen EP—A—0 031 489 et EP—A—0 026 265 décrivent des spectromètres dans lesquels un échantillon est disposé transversalement au champ $\vec{H}_0$ et dans lesquels une bobine de RMN entoure l'échantillon sur toute sa hauteur. Ces spectromètres effectuant une analyse en volume de l'échantillon ne sont pas adaptés à la tomographie.

Selon l'invention, un système de bobines électromagnétiques pour l'examen de corps humains au moyen de la Résonance Magnétique Nucléaire dite RMN, comporte un premier ensemble de bobines dit électro-aimant fournissant un champ magnétique $\vec{H}_0$ homogène dans lequel est placé le corps à observer, et un deuxième ensemble dit de R.M.N. comportant au moins une bobine disposée autour de la partie du corps à examiner fournissant un champ magnétique $\vec{H}_1$ haute fréquence HF perpendiculaire au champ $\vec{H}_0$ de l'électro-aimant, ledit deuxième ensemble étant aussi prévu peur réceptionner le champ porteur d'informations,

— le premier ensemble de bobines comportant au moins deux bobines symétriques suffisamment espacées pour permettre l'introduction du corps à observer entre elles deux avec son axe longitudinal disposé perpendiculairement au champ $\vec{H}_0$ de l'électro-aimant;
— caractérisé en ce que la bobine oui chaque bobine du deuxième ensemble de bobines détermine une mince tranche d'examen du corps à examiner.

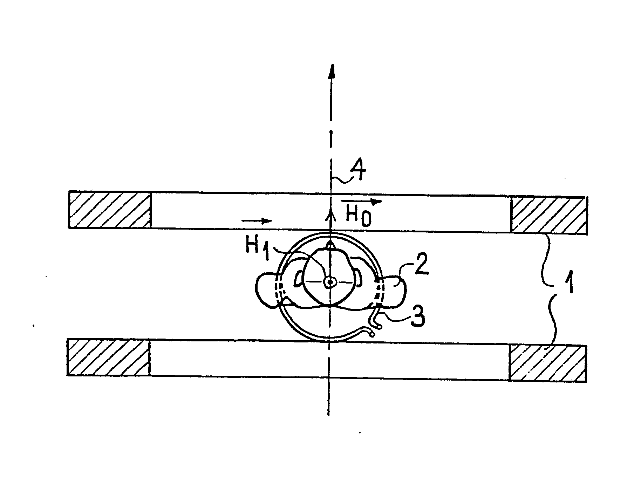

D'autres objets, caractéristiques et résultats de l'invention ressortiront de la description suivante donnée à titre d'exemple non limitatif et illustrée par la figure unique annexée qui représente très schématiquement, et vu en coupe partielle, un exemple de réalisation du système de bobines électromagnétiques de l'invention.

L'électro-aimant 1 a été symboliquement représenté ici comme un électro-aimant de type résistif comportant deux bobines de révolution autour de l'axe 4; il produit le champ $\vec{H}_0$ schématisé par la flèche le long de l'axe 4. Un tel électro-aimant est, généralement, constitué de plus de deux bobines pour obtenir un champ $\vec{H}_0$ homogène dans le volume d'examen, et par exemple de deux paires de bobines coaxiales.

Selon l'invention, les deux bobines les plus rapprochées (ici les seules représentées) sont suffisamment espacées pour permettre d'introduire le sujet à examiner 2 entre elles deux et de le disposer allongé en position transversale par rapport à l'axe de révolution 4 de l'électro-aimant, dans l'intervalle séparant ces deux bobines 1.

Cette organisation de l'électro-aimant, dont un exemple de réalisation particulièrement intéressant est décrit dans une demande de brevet européen EP—A—0 033 703 déposée par les deux Sociétés Demanderesses le même jour que le présent demande de brevet, permet une construction des bobines du deuxième ensemble, c'est-à-dire des bobines dites de RMN 3, conduisant à une détection optimisée de RMN.

En effet, dans des systèmes antérieurs illustrés par exemple par le contenu de la demande DE—A—2 755 956 et où le sujet à examiner était allongé longitudinalement dans l'électro-aimant, les bobines de RMN devaient, pour produire un champ hautefréquence $\vec{H}_1$ perpendiculaire au champ $\vec{H}_0$, être constituées, pour obtenir une image en coupe du torse ou de l'abdomen, de deux ensembles de spires de part et d'autre du tronc du patient, chacun ayant une forme dite de "selle de cheval". Cette disposition présentait plusieurs inconvénients nuisant à la sensibilité finale du système.

Dans le système de l'invention au contraire, le deuxième ensemble de bobines, c'est-à-dire la (ou les) bobines de RMN produisant le champ haute fréquence $\vec{H}_1$ est (sont) composées d'une ou de quelques spires disposées immédiatement autour du tronc du sujet; le champ $\vec{H}_1$ produit est bien perpendiculaire au champ $\vec{H}_0$.

Il est à noter qu'une bobine 3 de RMN à une seule spire permet de minimiser le bruit d'origine diélectrique généré par le patient.

Par ailleurs, ce deuxième ensemble de bobines (de RMN) peut comprendre des bobines distinctes pour l'émission et la réception HF dans une configuration très semblable à celle illustrée sur la figure. Dans ce cas, il peut être opportun d'utiliser une bobine d'émission HF à plusieurs spires et une bobine de réception à une spire unique, de manière à optimiser l'homogénéité du champ HP émis d'une part et à diminuer le bruit diélectrique d'autre part.

Enfin, il est encore possible de disposer plusieurs deuxièmes ensembles de bobines de RMN (3) coaxialement autour du sujet à examiner de manière à permettre l'examen de plusieurs parties de ce sujet se trouvant toutes dans le champ magnétique $\vec{H}_0$ de l'électro-aimant.

L'utilisation de telles bobines de RMN (3) disposées autour d'un sujet en position transversale dans l'électro-aimant présente plusieurs avantages conduisant à une amélioration de l'appareil qu'elles équipent.

L'homogénéité du champ $\vec{H}_1$ produit par la bobine RMN dans la zone d'examen, ou zone d'image, est meilleure qu'avec les bobines de l'art antérieur en "selle de cheval". La raison essentielle est que la zone à imager, habituellement une mince "tranche" du tronc humain, peut être inscrite à l'intérieur du volume délimité par une spire, ce qui n'est pas le cas pour une bobine en "selle de cheval".

Il s'ensuit qu'il est beaucoup plus facile de mettre en oeuvre les diverses techniques de RMN par séquences d'impulsions de haute fréquence. En particulier on peut utiliser les méthodes de restauration de l'aimantation nucléaire après sa mesure, techniques décrites par exemple par D. Jones et H. Sternlicht dans la revue "Journal of Magnetic Resonance" n° 6.167—196 (1972); on évite ainsi une partie des temps d'attente de la restauration par relaxation de l'aimantation. Le temps de pose total peut s'en trouver diminué d'un facteur nettement supérieur à 2.

De plus l'homogénéité de $\vec{H}_1$ évite des distorsions bidimensionnelles de l'image obtenue, distorsions qui obligeaient, dans l'art antérieur, à des corrections numériques complexes. La distorsion dûe à l'inhomogénéité résiduelle est plus facile à corriger dans le mesure où elle est exclusivement radiale. Notons de plus que, si on adopte un diamètre de bobine plus grand, l'inhomogénéité de $\vec{H}_1$ peut être diminuée dans la mesure du nécessaire.

L'intensité du champ $\vec{H}_1$ est plus forte qu'avec des bobines en "selle de cheval", toutes choses étant égales par ailleurs; elle est en effet optimale pour une bobine solénoïdale. L'émission d'un champ $\vec{H}_1$ donné requiert donc une puissance HF minimale. De plus, la réception du signal de RMN porteur d'informations est plus efficace: l'amplitude du signal détecté est plus forte et les diverses sources de bruit sont d'autant moins gênantes.

Il est donc plus facile de diminuer l'influence des bruits externes du patient: bruit thermique de la bobine et du préamplificateur HF. De plus, le bruit inductif généré par le patient est plus faible que pour une bobine en selle de cheval; la raison en est le moins grande extension spatiale du champ $\vec{H}_1$.

**Revendications**

1. Système de bobines électromagnétiques pour l'examen de corps humains au moyen de la Résonance Magnétique Nucléaire dite RMN, comportant un premier ensemble de bobines (1) dit électro-aimant fournissant un champ magnétique $\vec{H}_0$ homogène dans lequel est placé le corps à observer, et un deuxième ensemble (3) dit de R.M.N. comportant au moins une bobine disposée autour de la partie du corps a examiner fournissant un champ magnétique ($H_1$) haute fréquence (HF) perpendiculaire au champ $\vec{H}_0$ de l'électro-aimant, ledit deuxième ensemble étant aussi prévu pour réceptionner le champ porteur d'informations,

— le premier ensemble de bobines (1) comportant au moins deux bobines symétriques suffisamment espacées pour permettre l'introduction du corps à observer entre elles deux avec son axe longitudinal dispose perpendiculairement au champ $\vec{H}_0$ de l'électroaimant;

— caractérisé en ce que la bobine ou chaque bobine du deuxième ensemble détermine une mince tranche d'examen du corps à examiner.

2. Système de bobines selon la revendication 1, caractérisé en ce que le deuxième ensemble (3) comporte une bobine de RMN unique, composée d'une ou quelques spires, pour l'émission et la réception HF.

3. Système de bobines selon la revendication 1, caractérisé en ce que le deuxième ensemble (3) comporte deux bobines de RMN coaxiales autour de la partie du corps à examiner, une première de ces bobines fonctionnant en émission du champ HF ($\vec{H}_1$), et la seconde fonctionnant en réception du champ HF porteur d'informations.

4. Système de bobines selon la revendication 3, caractérisé en ce que la première bobine de RMN comporte plusieurs spires et la seconde comporte une spire unique de manière à optimiser l'homogénéité du champ HF émis d'une part et à diminuer le bruit diélectrique d'autre part.

5. Système de bobines selon la revendication 1, caractérisé en ce qu'il comporte plusieurs deuxièmes ensembles (3) disposés coaxialement autour du corps à examiner, de manière à permettre l'examen de plusieurs parties de ce corps se trouvant toutes dans le champ magnétique ($\vec{H}_0$) du premier ensemble de bobines (1).

6. Appareil d'imagerie par RMN, caractérisé en ce qu'il utilise, pour examiner des parties d'un corps humain, un système de bobines selon l'une des revendications précédentes.

## Patentansprüche

1. Elektromagnetisches Spulensystem zur Untersuchung menschlicher Körper mittels der magnetischen Kernresonanz, RMN genannt, mit einer ersten, Elektromagnet genannten Einheit von Spulen (1), die ein homogenes Magnetfeld $\vec{H}_0$ liefert, in dem der zu beobachtende Körper angeordnet ist, und mit einer zweiten Einheit (3), RMN-Einheit genannt, die mindestens eine den zu untersuchenden Teil des Körpers umgebende Spule aufweist und ein Hochfrequenz-Magnetfeld ($H_1$) senkrecht zum Feld $\vec{H}_0$ des Elektromagneten liefert, wobei diese zweite Einheit auch für den Empfang des informationstragenden Felds vorgesehen ist und die erste Spuleneinheit (1) mindestens zwei symmetrische und hinreichend weit voneinander entfernte Spulen enthält, um das Einschieben des zu beobachtenden Körpers zwischen diese beiden Spulen mit seiner Längsachse senkrecht zum Feld $\vec{H}_0$ des Elektromagneten zu er-

möglichen, dadurch gekennzeichnet, daß die Spule oder jede Spule der zweiten Einheit eine dünne Prüfschicht des zu untersuchenden Körpers bestimmt.

2. Spulensystem nach Anspruch 1, dadurch gekennzeichnet, daß die zweite Einheit (3) eine einzige RMN-Spule, die eine Windung oder einige Windungen aufweist, zum Senden und für den Empfang der Hochfrequenz enthält.

3. Spulensystem nach Anspruch 1, dadurch gekennzeichnet, daß die zweite Einheit (3) zwei koaxial den zu untersuchenden Teil des Körpers umgebende RMN-Spulen enthält, von denen die erste der Aussendung des Hochfrequenzfelds ($\vec{H}_1$) und die zweite dem Empfang des informationstragenden Hochfrequenzfelds dient.

4. Spulensystem nach Anspruch 3, dadurch gekennzeichnet, daß die erste RMN-Spule mehrere Windungen enthält und die zweite Spule eine einzige Windung aufweist, so daß einerseits die Homogenität des ausgesandten Hochfrequenzfelds optimisiert und andererseits das dielektrische Rauschen verringert wird.

5. Spulensystem nach Anspruch 1, dadurch gekennzeichnet, daß es mehrere zweite Einheiten (3) enthält, die koaxial um den zu untersuchenden Körper angeordnet sind, so daß eine Untersuchung mehrerer Teile dieses Körpers möglich ist, die sich alle im Magnetfeld ($\vec{H}_0$) der ersten Spuleneinheit (1) befinden.

6. Magnetisches Kernresonanz-Bildgerät, dadurch gekennzeichnet, daß es für die Untersuchung der Teile eines menschlichen Körpers ein Spulensystem nach einem der vorhergehenden Ansprüche verwendet.

## Claims

1. An electromagnetic coils system for examining human bodies by means of the nuclear magnetic resonance (NMR), comprising a first set (1) of coils called electromagnet, for producing a homogeneous magnetic field $\vec{H}_0$ in which the body to be observed is placed, and a second set (3) called NMR set comprising at least one coil placed around the portion of the body to be examined for producing a high-frequency (HF) magnetic field ($H_1$) at right angles to the field $\vec{H}_0$ of the electromagnet, wherein the second set is also provided to receive the information-carrying field and wherein the first set (1) of coils comprises at least two symmetrical coils spaced at a sufficient distance from each other to permit introduction of the body to be observed between said two coils in the transverse position at right angles to the field $\vec{H}_0$ of the electromagnet, characterized in that the coil or each coil of the second set determines a thin examination slice of the body to be examined.

2. A coils system according to claim 1, characterized in that the second set (3) comprises a single NMR coil having one turn or several turns for HF emission and reception.

3. A coils system according to claim 1, characterized in that the second set (3) comprises two coaxial NMR coils around the portion of the body to be examined, a first coil of said second set being adapted to emit the HF field ($\vec{H}_1$) and the second coil of said set being adapted to receive the information-carrying HF field.

4. A coils system according to claim 3, characterized in that the first NMR coil has a plurality of turns and the second coil has a single turn with a view on the same hand to optimize the uniformity of the emitted HF field and on the other hand to reduce the dielectric noise.

5. A coils system according to claim 1, characterized in that said system comprises a plurality of second sets (3) arranged coaxially around the body to be examined so as to permit examination of several portions of said body which are all located within the magnetic field ($\vec{H}_0$) of the first set (1) of coils.

6. An apparatus for NMR imagery, characterized in that said apparatus makes use of a coils system according to one of the preceding claims for examining portions of a human body.